# EUROPÄISCHE PATENTANMELDUNG

(11) **EP 0 569 883 A2**
(43) Veröffentlichungstag der Anmeldung: **18.11.1993**
(21) Anmeldenummer: 93107472.8
(22) Anmeldetag: 07.05.1993
(51) Int. Cl.: H02H 9/02, H02M 3/335, G05F 3/16

(54) **Schaltungsanordnung zur Begrenzung des Einschaltstroms in einer elektronischen Baugruppe**

(30) Priorität: 13.05.1992 DE 4215676
(71) Anmelder: SIEMENS AKTIENGESELLSCHAFT, D-80333 München (DE)
(72) Erfinder: Lang, Bernhard, Dipl.-Ing., W-7500 Karlsruhe 41 (DE)

(57) **Zusammenfassung**

Es wird eine Schaltungsanordnung zur Begrenzung des Einschaltstroms in einer elektronischen Baugruppe vorgeschlagen, die an eine Versorgungsspannungsquelle anschließbar ist. Ein Verbraucher ist über einen Widerstand anschließbar, der erfindungsgemäß steuerbar ausgebildet ist und nach Anschluß der Baugruppe an die Versorgungsspannungsquelle von einer Ansteuereinheit von einem hochohmigen in einen niederohmigen Zustand gesteuert wird.

Die Erfindung wird angewandt in elektronischen Baugruppen, insbesondere Stromversorgungsbaugruppen.

## Beschreibung

Die Erfindung betrifft eine Schaltungsanordnung zur Begrenzung des Einschaltstroms in einer elektronischen Baugruppe, insbesondere in einer Stromversorgungsbaugruppe, die an eine Versorgungsspannungsquelle anschließbar ist und einen Ladekondensator aufweist, an den über einen Widerstand ein Verbraucher anschließbar ist.

Elektronische Systeme sind üblicherweise aus elektronischen Baugruppen aufgebaut, die aus mit Bauelementen bestückten, rechteckigen Leiterplatten bestehen, welche reihenweise in Baugruppenträger einschiebbar sind. Die rückwärtige Seite jeder Baugruppe ist mit Kontaktmitteln, im allgemeinen mit einer Steckerleiste, versehen, die mit einer an der Rückwand des Baugruppenträgers angebrachten Federleiste eine Steckverbindung bilden. Die Buchsenleisten sind häufig untereinander über Busleitungen verbunden. Über die Steckverbinder werden nicht nur Daten- und Steuersignale von und zu den Baugruppen übertragen, sondern auch die Versorgungsspannung bzw. der Versorgungsstrom. Für die Inbetriebsetzung und Wartung ist es erforderlich, einzelne Baugruppen unter Spannung aus dem in Betrieb befindlichen System zu entnehmen oder einzustecken, wodurch insbesondere beim Stecken von einer Stromversorgungsbaugruppe hohe Einschaltströme entstehen. Diese hohen Einschaltströme können die Eingangsbauelemente der Baugruppe zerstören und Störungen im System bewirken.

Aus der deutschen Offenlegungsschrift 32 06 768 ist eine Schaltungsanordnung zur Einschaltstrombegrenzung bekannt. Bei dieser Schaltung ist ein Ladekondensator mit einem Verbraucher über einen Vorwiderstand an eine Versorgungsspannung angeschlossen. Dieser Vorwiderstand begrenzt den Einschaltstrom und wird nach Ablauf einer definierten Verzögerungszeit kurzgeschlossen, wodurch die Versorgungsspannung direkt an dem Ladekondensator und dem Verbraucher anliegt.

Der vorliegenden Erfindung liegt die Aufgabe zugrunde, eine Schaltungsanordnung zur Einschaltstrombegrenzung der eingangs genannten Art zu vereinfachen.

Diese Aufgabe wird dadurch gelöst, daß der Widerstand als steuerbarer Widerstand ausgebildet ist und daß die Versorgungsspannung einer Ansteuereinheit zugeführt ist, deren Ausgangsspannung nach dem Anschluß der Baugruppe an die Versorgungsspannungsquelle den steuerbaren Widerstand langsam von einem hochohmigen in einen niederohmigen Zustand steuert.

Eine vorteilhafte Ausgestaltung der Erfindung ergibt sich aus dem Unteranspruch.

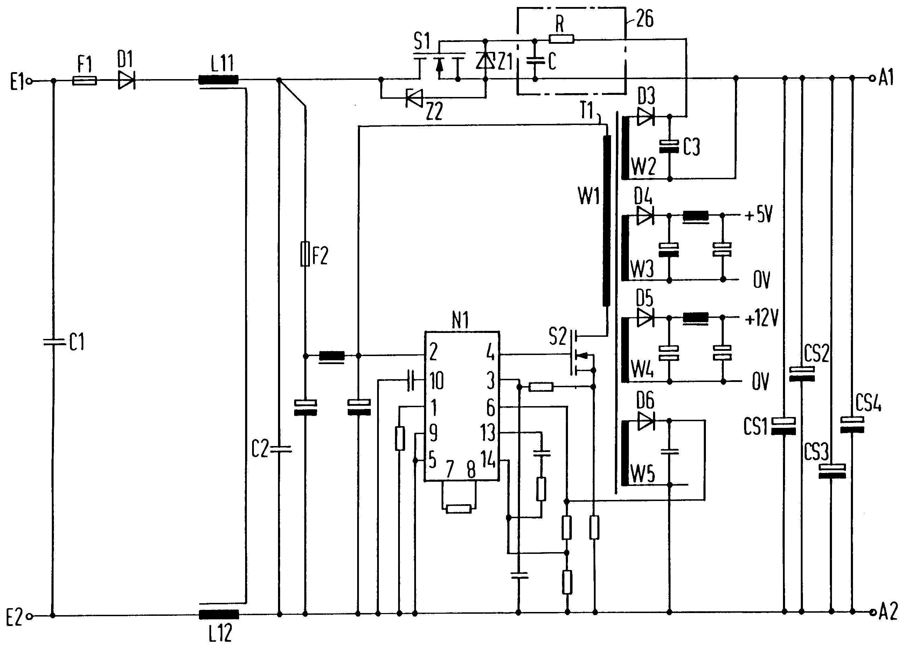

Anhand der Zeichnung, in der ein Ausführungsbeispiel der Erfindung dargestellt ist, werden die Erfindung, deren Ausgestaltungen sowie Vorteile näher erläutert.

Die Figur zeigt ein Schaltbild einer Stromversorgungsbaugruppe, an deren Eingangskontakten E1, E2 eine Gleichspannung einer hier nicht dargestellten Versorgungsspannungsquelle zuführbar und an deren Ausgangsklemmen A1, A2 ein ebenfalls nicht dargestellter Verbraucher parallel zu einem aus mehreren Kondensatoren CS1 ... CS4 bestehenden Lastkondensator anschließbar ist. Der Verbraucher braucht nicht direkt an den Ausgangsklemmen A1, A2 angeschlossen zu werden, sondern an einen an diesen Klemmen angeschlossenen Hauptspannungswandler. Für diesen Fall bilden im vorliegenden Beispiel ein an sich bekannter, mit mehreren Anschlüssen 1 ... 14 versehener Ansteuerbaustein N1, z. B. des Typs SI9110 der Firma Siliconix, ein Feldeffekttransistor S2, ein Wandlertransformator T1 mit seinen Wicklungen W1 und W2, ein Einweggleichrichter D3, C3 und ein Zeitglied ZG eine Ansteuereinheit zum Ansteuern eines steuerbaren Widerstandes S1. Die Funktion und Wirkungsweise der weiteren Bauelemente dieser Stromversorgungsbaugruppe, wie Eingangskondensator C1, Entkopplungsdiode D1, stromkompensierte Drossel L11, L12, Glättungskondensator C2, Schmelzsicherungen F1, F2, sowie der nicht näher bezeichneten äußeren Beschaltung des Ansteuerbausteins N1 sind zur Erläuterung der Erfindung ohne Bedeutung. Ebenso unwesentlich für die Erfindung sind die weiteren Wicklungen W3, W4 und W5 des Wandlertransformators T1, die z. B. sekundäre Überwachungsbaugruppen dieser Stromversorgungsbaugruppe unabhängig vom Betriebszustand des Hauptspannungswandlers speisen. Auf diese Teile braucht daher nicht näher eingegangen zu werden. Der steuerbare Widerstand S1 ist als Feldeffekttransistor ausgebildet, der als Source-Folger geschaltet ist und dessen Gate-Source-Spannung beim Anlegen der Eingangsspannung an den Eingangsklemmen E1, E2 0 Volt betragt, wodurch die Source-Drain-Strecke im hochohmigen Zustand ist. Die Eingangsspannung liegt ebenfalls an dem Ansteuerbaustein N1, der den Feldeffekttransistor S2 mit einem Signal in Form von Rechteckimpulsen ansteuert und eine dynamische Begrenzung seines Source-Stromes bewirkt. Der Transistor S2 wechselt entsprechend der Frequenz dieses Signals seine Schaltzustände von "Schalter offen" nach "Schalter geschlossen" und umgekehrt, und der Stromfluß in der Wicklung W1 ändert sich, wodurch daraufhin in die Wicklung W2 eine Spannung induziert wird. Diese Spannung wird durch den Einweggleichrichter D3, C3 gleichgerichtet und dem Zeitglied ZG zugeführt. Das Zeitglied ZG in Form eines RC-Gliedes ist so bemessen, daß der Feldeffekttransistor S1 nach Erreichen der Gate-Source-Schwellenspannung durchsteuert. Der Widerstand der Drain-Source-Strecke verringert sich langsam, und die Ladespannung des Ladekondensators CS1 ... CS4 steigt langsam an, wodurch eine Zerstörung der Bauelemente, insbesondere der Eingangsbauelemente und der Eingangsklemmen E1, E2, verhindert wird. Zenerdioden Z1, Z2 schützen den Feldeffekttransistor S1 vor Überspannungen.

Es ist selbstverständlich möglich, zum Ansteuern des Feldeffekttransistors S1 einen Spannungsteiler mit nachgeschaltetem Zeitglied vorzusehen. Wesentlich ist, daß eine zur Eingangsspannung zeitlich verzögerte Spannung an dem Zeitglied zum Steuern des Transistors S1 vorliegt.

## Patentansprüche

1. Schaltungsanordnung zur Begrenzung des Einschaltstroms in einer elektronischen Baugruppe, insbesondere in einer Stromversorgungsbaugruppe, die an eine Versorgungsspannungsquelle anschließbar ist und einen Ladekondensator aufweist, an den über einen Widerstand ein Verbraucher anschließbar ist,
**dadurch gekennzeichnet,**
- daß der Widerstand als steuerbarer Widerstand (S1) ausgebildet ist und
- daß die Versorgungsspannung einer Ansteuereinheit (N1, S2, W1, W2, D3, C3, ZG) zugeführt ist, deren Ausgangsspannung nach dem Anschluß der Baugruppe an die Versorgungsspannungsquelle den steuerbaren Widerstand (S1) langsam von einem hochohmigen in einen niederohmigen Zustand steuert.

2. Schaltungsanordnung nach Anspruch 1, **dadurch gekennzeichnet,**
- daß der steuerbare Widerstand (S1) ein Feldeffekttransistor ist und
- daß die Ansteuereinheit (N1, S2, W1, W2, D3, C3, ZG) ein Zeitglied (ZG) aufweist, das den Feldeffekttransistor derart ansteuert, daß die Ladespannung des Ladekondensators (CS1 ... CS4) langsam ansteigt.
